# EUROPÄISCHE PATENTSCHRIFT

(11) **EP 1 711 044 B1**
(45) Veröffentlichungstag und Bekanntmachung des Hinweises auf die Patenterteilung: **22.05.2013**
(21) Anmeldenummer: 05026243.5
(22) Anmeldetag: 01.12.2005
(51) Int. Cl.: H05K 13/04, H05K 3/34

(54) **Verfahren zur Übertragung von elektrischen Bauelementen auf eine Oberfläche**
Method of transferring electrical components onto a surface
Méthode pour transférer des composants électriques sur une surface

(30) Priorität: 02.12.2004 DE 102004058201
(43) Veröffentlichungstag der Anmeldung: 11.10.2006
(73) Patentinhaber: Fraunhofer-Gesellschaft zur Förderung der angewandten Forschung e.V., 80686 München (DE)
(72) Erfinder: Jung, Erik, Dipl.-Phys., 14612 Falkensee (DE)
(74) Vertreter: Gagel, Roland

(56) Entgegenhaltungen:
- WO-A-89/08927
- JP-A- 2003 046 222
- JP-A- 2003 178 624
- ANTHONY WALKER AND DANIEL F. BALDWIN: "Initial INventigations into Low-Cost Ultra-Fine Pitch Solder Printing Process Based on Innovative Laser Printing Technology" IEEE TRANSACTIONS ON ELECTRONICS PACKAGING MANUFACTUREING, Bd. 22, Nr. 4, 4. Oktober 1999 (1999-10-04), Seiten 303-307, XP002480584

## Beschreibung

### Technisches Anwendungsgebiet

Die vorliegende Erfindung betrifft ein Verfahren zur Übertragung von Bauelementen, bei dem elektrische Bauelemente von einem Träger aufgenommen, über einer Oberfläche positioniert und auf die Oberfläche übertragen werden.

Das vorliegende Verfahren wird in der Mikrotechnologie und Mikrosystemtechnik, insbesondere im Bereich der Elektrotechnik angewendet.

### Stand der Technik

Das Positionieren und Übertragen von SMD Bauelementen (Surface Mounted Devices) auf technische Oberflächen, wie bspw. gedruckte Schaltungen oder Leiterplatten, wird heute üblicherweise im so genannten 'Pick-and-Place'-Verfahren durch automatisierte Bestückungsvorrichtungen vorgenommen. Derartige Vorrichtungen weisen im Allgemeinen zumindest einen beweglichen Bestückungskopf auf. Die Bauteile werden von dem Bestückungskopf aufgenommen (,Pick') oder ihm anderweitig aus einem Bauteilereservoir zugeführt. Der Bestückungskopf positioniert die Bauteile über der technischen Oberfläche, setzt sie ab und überträgt sie damit auf die Oberfläche (,Place'). Die Positionierung des Bestückungskopfes erfolgt zumeist unter Verwendung optischer Verfahren. Um ein möglichst schnelles Bestücken mit unterschiedlichen Bauelementen zu ermöglichen, weisen moderne Bestückungsvorrichtungen eine Mehrzahl von Bestückungsköpfen auf. Ein solcher Bestückungsautomat ist bspw. in US 5 862 586 offenbart.

Nachteilig an den bekannten Realisierungen des Pick-and-Place-Verfahrens ist, dass diese sich zur Positionierung und Übertragung kleinster Bauelemente mit Dimensionen in der Größenordnung von 0,5 mm und kleiner aufgrund von Problemen mit elektrostatischen Aufladungen nicht eignen. Zudem sind die dabei einzuhaltenden mechanischen Toleranzen bei entsprechenden Pick-and-Place-Vorrichtungen schlecht oder wegen des damit verbundnen enormen Aufwandes nicht wirtschaftlich realisierbar.

Darüber hinaus ist die Bestückungsleistung von heute verfügbaren Pick-and-Place Bestückungsverfahren durch die Zahl der gleichzeitig arbeitenden Bestückungsköpfe sowie die Bestückungsleistung der einzelnen Bestückungsköpfe begrenzt.

Aus der Veröffentlichung von ANTHONY WALKER AND DANIEL F. BALDWIN: "Initial Inventigations into Low-Cost Ultra-Fine Pitch Solder Printing Process Based on Innovative Laser Printing Technology" IEEE TRANSACTIONS ON ELECTRONICS PACKAGING MANUFACTUREING, Bd. 22, Nr. 4, 4. Oktober 1999 (1999-10-04), Seiten 203-207, XP002480584, ist ein Verfahren zur Übertragung von Lotpartikeln durch ein elektrophotographisches Verfahren bekannt geworden, wobei die Lotpartikel von einem Träger aufgenommen, über einer Oberfläche positioniert und auf die Oberfläche übertragen werden.

Der Erfindung liegt die Aufgabe zugrunde, ein Verfahren anzugeben, das die Positionierung und Übertragung von kleinsten Bauelementen, insbesondere von elektrischen Bauelementen mit Dimensionen in der Größenordnung von 0,5 mm oder kleiner, auf eine Oberfläche günstig, schnell und flexibel ermöglicht.

### Darstellung der Erfindung

Die Aufgabe wird mit dem Verfahren gemäß Patentanspruch 1 gelöst, der ein Verfahren beschreibt, bei dem elektrische Bauelemente von einem Träger aufgenommen, über einer technischen Oberfläche positioniert und auf die technische Oberfläche übertragen werden.

Vorteilhafte Ausgestaltungen sind Gegenstand der Unteransprüche sowie der Beschreibung, insbesondere dem Ausführungsbeispiel zu entnehmen.

Das erfindungsgemäße Verfahren nach dem Oberbegriff des Anspruchs 1 zeichnet sich durch folgende Schritte aus:
- Vorsehen eines elektrostatisch aufladbaren Trägers, der eine Oberfläche mit einer Fotoleiterschicht aufweist,
- Elektrostatisches Aufladen der Fotoleiterschicht des Trägers und Erzeugen einer Ladungsstruktur, die eine Geometrie aufweist, mit der die einzelnen Bauelemente auf die technische Oberfläche übertragen werden sollen,
- Zuführen und Aufbringen der Bauelemente auf die Oberfläche der elektrostatisch geladenen Fotoleiterschicht, wobei nur entsprechend der Ladungsstruktur der Fotoleiterschicht vorgesehene Bauelemente daran haften bleiben,
- Entfernen der übrigen Bauelemente von dem Träger,
- In Kontaktbringen der auf der Fotoleiterschicht haftenden Bauelemente mit der technischen Oberfläche und Übertragen der Bauelemente auf die technische Oberfläche, so, dass nach Entfernen des Trägers die Bauelemente auf die technische Oberfläche übertragen und dort platziert oder montiert sind.

Die Erfindung basiert auf der Idee einen Träger derart strukturiert elektrostatisch aufzuladen, dass die zu übertragenden Bauelemente aufgrund elektrostatischer Haftung gemäß der auf den Träger aufgebrachten Ladungsstruktur haften bleiben und auf die technische Oberfläche übertragen werden können.

Erfindungsgemäß weist ein vorzusehender Träger an seiner Oberfläche eine Fotoleiterschicht auf. Der Träger selbst kann je nach Anwendung aus unterschiedlichem Material bestehen und unterschiedlich geformt sein. Eine Möglichkeit bietet die Verwendung von flexiblem Band mit entsprechender fotoleitender Beschichtung als Träger. Als besonders sinnvoll für die gerätetechnische Umsetzung des Verfahrens sind ebene, plattenförmige Träger oder Träger die eine Zylinderform aufweisen aus Metall, bspw. Aluminium. Die Fotoleiterschicht besteht üblicherweise aus einer dünnen, isolierenden Schicht auf einem leitenden Substrat. Als fotoleitende Materialien kommen verschiedene Stoffverbindungen wie bspw. As2Se3, SeTe, ZnO, organische Mehrschichtanordnungen oder amorphes Silizium zur Anwendung. Die Dicke der Fotoleiterschicht liegt üblicherweise zwischen 10 - 100 µm.

In dem zweiten Verfahrensschritt erfolgt zunächst das elektrostatische Aufladen der Fotoleiterschicht. Ein bekanntes Verfahren hierzu ist das der Koronarentladung. Damit wird auf die Fotoschicht ein homogenes Oberflächenpotential aufgebracht, das je nach Fotoleitermaterial und Koronarspannung bis zu 900 Volt, bei einer Oberflächenladungsdichte von bis zu 100 nC/cm² betragen kann.

Nach der homogenen Aufladung wird auf der Fotoleiterschicht eine Ladungsstruktur erzeugt, die eine Geometrie aufweist, mit der die einzelnen Bauelemente auf die technische Oberfläche übertragen werden sollen. Die einzelnen Bauelemente werden dabei in der Ladungsstruktur vorzugsweise als zwei-dimensionale Projektion (Umriss) der äußeren dreidimensionalen Form der einzelnen entsprechend angeordneten Bauelemente abgebildet. Gilt es bspw. eine Vielzahl von gleichartigen kugelförmigen Kontaktelementen auf eine technische Oberfläche zu übertragen, so wird vorzugsweise eine geometrische Ladungsstruktur auf die Fotoleiterschicht aufgebracht, die aus einer Vielzahl entsprechend angeordneter kreisförmiger Ladungsinseln besteht, die einen Durchmesser aufweisen, der dem Durchmesser der kugelförmigen Kontaktelemente gleich oder annähernd gleich ist.

Das Erzeugen der Ladungsstruktur in der zunächst elektrostatisch homogen geladenen Fotoleiterschicht erfolgt in an sich bekannter Weise durch Belichtung mit einer Lichtquelle bestimmter Wellenlänge und Energie mit oder ohne einer Maske. Als Lichtquellen kommen unter anderem Laser in Betracht, da sie einen scharf gebündelten, kohärenten Lichtstrahl erzeugen, aber auch LED's können zum Einsatz kommen. Die Belichtung bewirkt lokal eine Entladung der Fotoleiterschicht und damit je nach eingesetzter Technik eine Fotostrukturierung von bis zu 1 µm Auflösung. Alle Bereiche außerhalb der gewünschten Ladungsstruktur werden dementsprechend entladen. Demzufolge unterscheidet sich die gewünschte Ladungsstruktur als geladene Bereiche (,Ladungsinseln') von dem ungeladenen Bereich außerhalb der Struktur.

Im dritten Verfahrensschritt werden die zu übertragenden Bauelemente dem Träger zugeführt und auf die nun strukturiert elektrostatisch geladene Fotoleiterschicht aufgebracht. Für das Zuführen der Bauelemente kommen verschiedene Techniken in Betracht, die u.a. von der gerätetechnischen Ausführung und vor allem von der Gestaltung des Trägers abhängen. Die Bauelemente werden im Allgemeinen aus einem entsprechenden Reservoir zugeführt und auf der Fotoleiterschicht derart verteilt, dass an allen entsprechend der Ladungsstruktur vorgesehenen Ladungsinseln aufgrund der elektrostatischen Anziehung ein Bauelement haften bleibt.

In einer vorteilhaften Ausbildung des Verfahrens werden die Bauelemente vor dem Aufbringen auf den Träger entgegengesetzt zur Oberflächenladung der Fotoleiterschicht (Ladungsinseln) elektrisch aufgeladen.

In einer weiteren vorteilhaften Ausbildung des Verfahrens sind die Bauelemente an einer Seite mit einer dielektrischen Schicht beschichtet. Dies führt nach dem Aufbringen der Bauelemente auf die strukturiert geladene Fotoleiterschicht zu einem räumlich ausgerichteten Anhaften der Bauelemente. Beispielsweise kann durch eine selektive dielektrische Beschichtung auf einer LED-Rückseite noch im Waferverbund eine korrekte Ausrichtung (oben/ unten) bei der erfindungsgemäßen Übertragung von LED's sichergestellt werden.

Idealerweise werden bei einem Verfahrensdurchgang identische Bauelemente verwendet. Es kommen dabei Bauelemente, insbesondere elektrische Bau- oder Kontaktelemente, in Betracht, die Dimensionen in der Größenordnung von 0,5 mm und kleiner aufweisen. Aufgrund der Größenordnung der im Verfahren auf die Bauelemente wirkenden elektrostatischen Kräfte, kommt es erst bei Bauteilen dieser Dimensionen zu einer Kompensation der Gravitationskräfte durch die elektrostatischen Kräfte. Typische Anwendungen des Verfahrens sind das Übertragen von elektrischen Chips oder kugelförmigen Kontaktelementen, so genannten 'Contact-Balls', mit Dimensionen in der Größenordnung von 150 µm oder darunter auf Flip Chips, BGA's (Ball Grid Array's) und CSP's (Chip Size Packaging). Darüber hinaus kommen auch Bauelemente aus chemischen oder biologischen Substanzen, vor allem aus elektrisch geladenen oder elektrisch polarisierbaren Substanzen, wie bspw. Proteine, RNA, DNA, in Betracht.

Im vierten Verfahrensschritt werden die übrigen Bauelemente, d.h. diejenigen Bauelemente die nicht an den Ladungsinseln haften, von der Oberfläche des Trägers entfernt. Das Entfernen der Bauelemente kann durch den Einsatz mechanischer Hilfsmittel, durch Fluidströme, durch Nutzung der Gravitationskraft, von elektrostatischen, magnetischen oder elektromagnetischen Kräften oder einer Kombination daraus erfolgen. Sinnvollerweise werden die von der Oberfläche des Trägers entfernten Bauelemente wieder dem entsprechenden Bauelementereservoir zugeführt.

Im fünften und letzten Verfahrensschritt werden die an der Fotoleiterschicht des Trägers haftenden Bauelemente auf die technische Oberfläche übertragen. Dabei wird abhängig von der gerätetechnischen Realisierung ggf. zunächst der Träger über der technischen Oberfläche positioniert. Anschließend wird der Träger mit der technischen Oberfläche in Wirkverbindung gebracht, so dass nach Entfernen des Trägers die an dessen Fotoleiterschicht haftenden Bauelemente auf die technische Oberfläche übertragen, platziert oder montiert sind.

In einer weiteren Ausbildung des Verfahrens kann der Vorgang des Übertragens zudem durch eine Entladung oder gegenpolige Aufladung der Fotoleiterschicht unterstützt werden, so dass die Bauelemente von der Fotoleiterschicht elektrisch abgestoßen werden.

Je nach gerätetechnischer Realisierung kann das Entfernen des Trägers, bspw. im Fall von an sich bekannten Rolle-Rolle-Verfahren, auch derart erfolgen, dass sich im Verfahren zugeordnete Oberflächenpunkte von Fotoleiterschicht des Trägers und Oberflächenpunkte der technischen Oberfläche, die zunächst in Wirkverbindung stehen, voneinander entfernen.

Bei einer weiteren vorteilhaften Weiterbildung des Verfahrens wird die Fotoleiterschicht nach der Übertragung der Bauelemente auf die technische Oberfläche elektrisch entladen, so dass eine Wiederholung des Verfahrens mit demselben Träger möglich ist. Eine derartige Wiederholung kann genutzt werden, um weitere Bauteile auf eine weitere technische Oberfläche, bspw. ein Substrat, aufzubringen oder um andersartige Bauteile auf dieselbe technische Oberfläche aufzubringen.

Das erfindungsgemäße Verfahren ermöglicht ein hochflexibles, kostengünstiges und auf hohen Durchsatz optimiertes Übertragen von Bauelementen auf technische Oberflächen.

### Kurze Beschreibung der Zeichnungen

Die Erfindung wird nachstehend ohne Beschränkung des allgemeinen Erfindungsgedankens anhand von Ausführungsbeispielen und unter Bezugnahme auf die Zeichnungen exemplarisch beschrieben. Dabei zeigen:

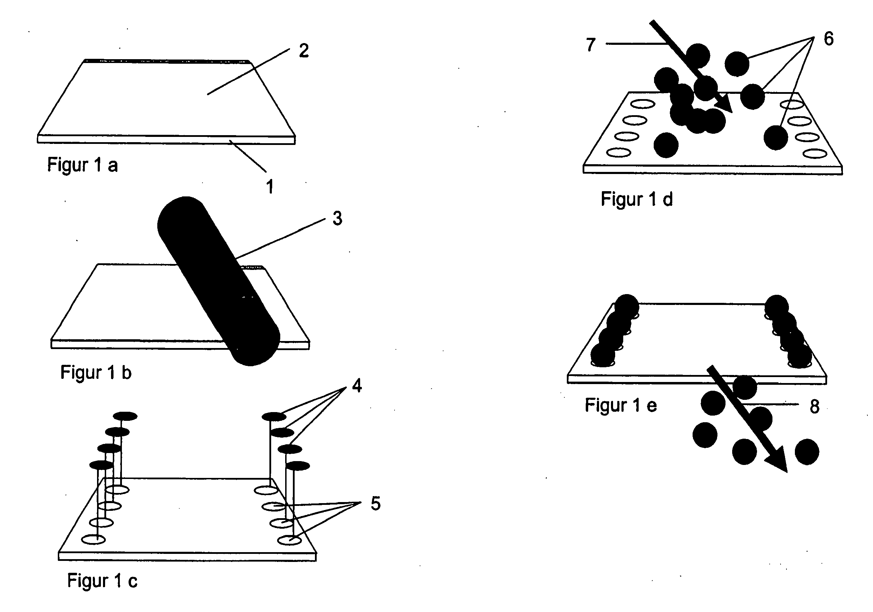

- Fig. 1a-i: Schematische Darstellung der Verfahrensschritte bei der Übertragung von kugelförmigen Kontaktelementen auf eine technische Oberfläche bei einem Platte-Platte-Verfahren.

### Wege zur Ausführung der Erfindung

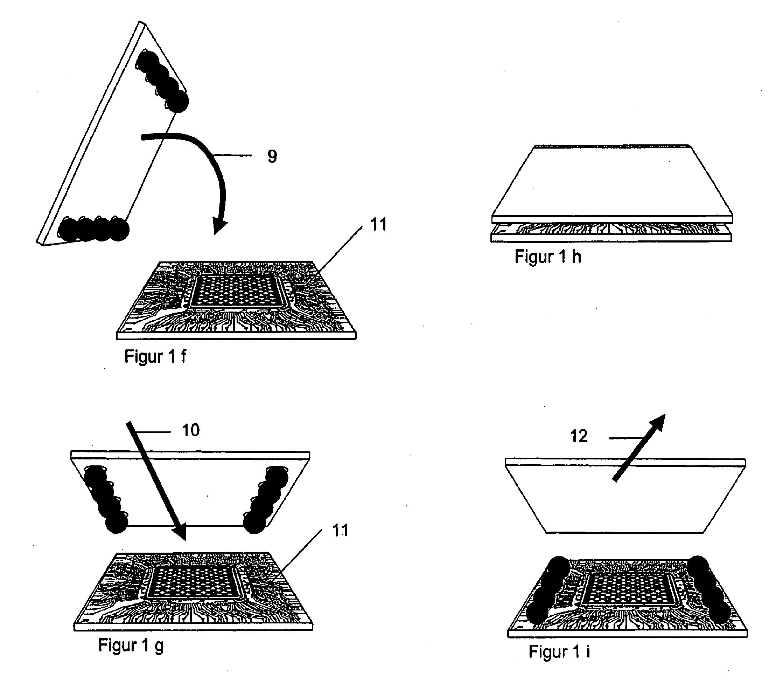

Die Figuren 1 a bis 1 i zeigen schematisch die einzelnen Schritte des erfindungsgemäßen Verfahrens bei einem Übertragen von kugelförmigen Kontaktelementen 6 auf eine technische Oberfläche 11.

Figur 1a zeigt einen Träger 1, der als viereckige Platte ausgebildet ist. Auf der sichtbaren, oben liegenden Oberfläche des Trägers 1 ist eine Fotoleiterschicht 2 aufgebracht.

Figur 1b zeigt schematisch das homogene, elektrostatische Aufladen der Fotoleiterschicht 2 mit einer Einheit (Korona) zur Koronaraufladung 3 der Fotoleiterschicht 2. Üblicherweise besteht die Korona 3 aus einem dünnen Draht, bspw. aus Wolfram, in einem Gehäuse. Die weißen Flächen repräsentieren dabei die aufgebrachte homogene Ladungsverteilung 13.

Figur 1c zeigt die durch ein elektrofotografisches Verfahren auf dem Träger 1 erzeugte Ladungsstruktur. Nach der homogenen Aufladung wird auf der Fotoleiterschicht 2 eine Ladungsstruktur erzeugt, die eine Geometrie aufweist, mit der die einzelnen Kontaktelemente 6 auf die technische Oberfläche 11 übertragen werden sollen. In dem vorliegenden Fall sollen jeweils zwei mal vier kugelförmige Kontaktelemente 6 übertragen werden, wobei jeweils vier Kontaktelemente 6 an den abgebildeten Positionen (weiße Kreise) des Trägers 1 nebeneinander in Reihe angeordnet werden sollen. Die einzelnen Kontaktelemente 6 werden dabei in der Ladungsstruktur als zwei-dimensionalen Projektion 4 der äußeren dreidimensionalen Form der einzelnen entsprechend angeordneten Kontaktelemente 6 abgebildet. Gilt es, wie im vorliegenden Ausführungsbeispiel, acht gleichartige kugelförmige Kontaktelemente 6 auf eine technische Oberfläche 11 zu übertragen, so wird eine geometrische Ladungsstruktur auf die Fotoleiterschicht 2 aufgebracht, die aus acht entsprechend angeordneten kreisförmigen Ladungsinseln 5 besteht, die einen Durchmesser aufweisen, der dem Durchmesser der kugelförmigen Kontaktelemente 6 gleich oder annähernd gleich ist. Allerdings sind die Formgebung und die Dimensionierung der Ladungsinseln in gewissen Grenzen auch unabhängig vom Umriss der Bauelemente möglich. Wesentlich dabei ist, dass die Ladungsinseln eine Dimensionierung derart aufweisen, dass einerseits die Ladungsinselfläche ausreicht, um ein elektrostatisches Anhaften nur jeweils eines Bauelements zu garantieren, und dass andererseits die Formgebung der Ladungsinsel zu einer exakten Positionierung des Bauelementes auf der Fotoleiterschicht führt.

Durch die Belichtung der Fotoleiterschicht 2 wurden alle Bereiche der Fotoleiterschicht 2 entladen, die außerhalb der zweidimensionalen Projektion 5 der zu übertragenden Kontaktelemente 6 liegen.

Figur 1d zeigt das Aufbringen 7 der kugelförmigen Kontaktelemente 6 auf die Fotoleiterschicht 2. In der hier gezeigten Figur ist angedeutet, dass die Bauelemente auf den Träger aufgeschüttet werden. Darüber hinaus sind eine Vielzahl von weiteren mechanischen oder elektromechanischen Methoden und Techniken des Zuführens, Aufbringens und Verteilens von Bauelementen auf die Fotoleiterschicht möglich. Grundsätzlich kann dabei zwischen Techniken unterschieden werden, bei denen die Bauelemente ungeordnet oder geordnet zugeführt werden.

Figur 1e veranschaulicht, dass durch elektrostatische Wechselwirkungen an jeder Ladungsinsel 5 ein Kontaktelement 5 haftet. Darüber hinaus wird das Entfernen 8 aller übrigen Kontaktelemente 6 vom Träger 1 veranschaulicht. Im einfachsten Fall geschieht dies durch einfaches Kippen des Trägers. Darüber hinaus ist bspw. der Einsatz von Druckluft oder mechanischer Mittel zur Entfernung aller übrigen Kontaktelemente möglich.

Die Figuren 1f und 1g veranschaulichen das Zuführen 9 und Positionieren 10 des Trägers 1 über der technischen Oberfläche 11.

Figur 1h veranschaulicht das Übertragen der Kontaktkörper 6, die an der Fotoleiterschicht 2 des Trägers 1 haften, auf die technische Oberfläche 11. Dabei wird der Träger 1 mit der technischen Oberfläche 11 derart in Wirkverbindung gebracht, dass nach Entfernen 12 (Figur 1i) des Trägers 1 die an dessen Fotoleiterschicht 2 haftenden Kontaktelemente 6 auf die technische Oberfläche 11 übertragen und dort platziert oder montiert sind.

### Bezugszeichenliste

- 1: Träger
- 2: Fotoleiterschicht
- 3: Korona, Einheit zur Koronaraufladung
- 4: 2-dimensionale Projektion eines 3-dimensionalen Kontaktelements
- 5: Ladungsinsel
- 6: Kontaktelemente
- 7: Aufbringen von Kontaktelementen auf die Fotoleiterschicht
- 8: Entfernen überschüssiger Kontaktelemente vom Träger
- 9: Zuführen des Trägers zur technischen Oberfläche
- 10: Positionieren des Trägers relativ zur technischen Oberfläche
- 11: Technische Oberfläche eines steifen, starren Substrats
- 12: Entfernen des Trägers von der technischen Oberfläche

## Patentansprüche

1. Verfahren zur Übertragung von elektrischen Bauelementen(6), insbesondere elektrischen Chips, LED's oder kugelförmigen elektrischen Kontaktierelementen, bei dem Bauelemente (6), von einem Träger (1) aufgenommen, über einer Oberfläche (11) positioniert und auf die Oberfläche (11) übertragen werden, **gekennzeichnet durch** folgende Schritte:
- Vorsehen eines elektrostatisch aufladbaren Trägers (1), der eine Oberfläche mit einer Fotoleiterschicht (2)aufweist,
- Elektrostatisches Aufladen der Fotoleiterschicht (2) des Trägers (1) und Erzeugen einer Ladungsstruktur, die eine Geometrie aufweist, mit der die einzelnen Bauelemente (1) auf die Oberfläche (11) übertragen werden sollen,
- Zuführen und Aufbringen der Bauelemente (6) auf die Oberfläche der elektrostatisch geladenen Fotoleiterschicht (2), wobei nur entsprechend der Ladungsstruktur der Fotoleiterschicht (2) vorgesehene Bauelemente (6) daran haften bleiben,
- Entfernen der übrigen Bauelemente (6) von dem Träger (1),
- In Kontaktbringen der auf der Fotoleiterschicht (2) haftenden Bauelemente (6) mit der Oberfläche (11) und Übertragen der Bauelemente (6) auf die Oberfläche (11),
wobei **durch** selektives Beschichten der Bauelemente (6) mit einer dielelektrischen Schicht ein ausgerichtetes Anhaften der Bauelemente (6) an dem Träger (1) erfolgt.

2. Verfahren nach Anspruch 1,
**dadurch gekennzeichnet, dass** identische Bautelemente(6) verwendet werden.

3. Verfahren nach einem der Ansprüche 1 bis 2,
**dadurch gekennzeichnet, dass** das elektrostatische Aufladen der Fotoleiterschicht (2) mittels einer Koronaaufladung erfolgt.

4. Verfahren nach einem der Ansprüche 1 bis 3,
**dadurch gekennzeichnet, dass** das Erzeugen der Ladungsstruktur durch Belichten der Fotoleiterschicht (2) erfolgt.

5. Verfahren nach einem der Ansprüche 1 bis 4,
**dadurch gekennzeichnet, dass** das Erzeugen der Ladungsstruktur durch ein elektrofotografisches Verfahren erfolgt.

6. Verfahren nach einem der Ansprüche 1 bis 5,
**dadurch gekennzeichnet, dass** die Bauelemente (6) vor dem Aufbringen auf den Träger (1) entgegengesetzt zur Oberflächenladung der strukturiert geladenen Fotoschicht (2) elektrisch aufgeladen werden.

7. Verfahren nach einem der Ansprüche 1 bis 6,
**dadurch gekennzeichnet, dass** das Entfernen der Bauelemente (6) mittels der auf die Bauelemente (6) wirkenden Gravitationskraft erfolgt.

8. Verfahren nach einem der Ansprüche 1 bis 7,
**dadurch gekennzeichnet, dass** das Entfernen der Bauelemente (6) mittels eines Fluidstromes erfolgt.

9. Verfahren nach einem der Ansprüche 1 bis 8,
**dadurch gekennzeichnet, dass** vor dem in Kontaktbringen ein Positionieren und Ausrichten des Trägers (1) relativ zur Oberfläche (11) erfolgt.

10. Verfahren nach einem der Ansprüche 1 bis 9,
**dadurch gekennzeichnet, dass** beim Übertragen der Bauelemente (6) auf die Oberfläche (11), die Fotoleiterschicht (2) entladen oder gegenpolig aufgeladen wird.

11. Verfahren nach einem der Ansprüche 1 bis 10,
**dadurch gekennzeichnet, dass** nach dem Übertragen der Bauelemente (6) auf die Oberfläche (11) die Fotoleiterschicht (2) entladen wird.

12. Verfahren zur Übertragung von Bauelementen, bei dem durch wiederholtes Anwenden des Verfahrens nach einem der Ansprüche 1 bis 11 auf eine Oberfläche (11) unterschiedliche Bauelemente (6) aufgebracht werden.

13. Verwendung des Verfahrens nach einem der Ansprüche 1 bis 12, zur Positionierung und Übertragung von kugelförmigen, elektrischen Kontaktelementen (6) oder elektrischen Chips auf eine Oberfläche, insbesondere eine Leiterplatte.

14. Verwendung des Verfahrens nach einem der Ansprüche 1 bis 12, zur Positionierung und Übertragung von elektrischen Kontaktelementen (6), insbesondere von Contact-Balls, auf Flip Chips, BGA's (Ball Grid Array's) und CSP's (Chip Size Packaging).

## Claims

1. A method for transferring electrical components (6), in particular electrical chips, LEDs or spherical electrical contacting elements, in which components (6), accommodated by a substrate (1), are positioned above a surface (11) and transferred onto the surface (11), **characterized by** the following steps:
- provision of an electrostatically chargeable substrate (1) which has a surface with a photo-conductive layer (2),
- electrostatic charging of the photo-conductive layer (2) of the substrate (1) and generation of a charge structure having a geometry with which the individual components (1) are to be transferred onto the surface (11),
- feeding and placement of the components (6) onto the surface (11) of the electrostatically charged photo-conductive layer (2), wherein only components (6) provided in accordance with the charge structure of the photo-conductive layer (2) remain attached thereto,
- removal of the remaining components (6) from the substrate (1),
- bringing of the components (6) that remain attached to the photo-conductive layer (2) into contact with the surface (11) and transferral of the components (6) onto the surface (11)
wherein by selective coating of the components (6) with a dielectric layer, an aligned adhesion of the components (6) on the substrate is obtained.

2. The method according to Claim 1,
**characterized in that**
identical components (6) are used.

3. The method according to one of Claims 1 to 2,
**characterized in that**
the photo-conductive layer (2) is electrostatically charged by means of a corona charging process.

4. The method according to any one of Claims 1 to 3,
**characterized in that**
the charge structure is generated by exposure of the photo-conductive layer (2).

5. The method according to any one of Claims 1 to 4,
**characterized in that**
the charge structure is generated by an electrophotographic method.

6. The method according to any one of Claims 1 to 5,
**characterized in that**
before being placed on the substrate (1) the components (6) are electrically charged in the opposite sense to the surface charge of the photo-conductive layer (2), which is charged in a structured manner.

7. The method according to any one of Claims 1 to 6,
**characterized in that**
the components (6) are removed by means of the gravitational force acting on said components (6).

8. The method according to any one of Claims 1 to 7,
**characterized in that**
the components (6) are removed by means of a fluid flow.

9. The method according to any one of Claims 1 to 8,
**characterized in that**
before the components (6) are brought into contact, the substrate (1) is positioned and aligned relative to the surface (11).

10. The method according to any one of Claims 1 to 9,
**characterized in that**
when the components (6) are transferring to the surface (11), the photo-conductive layer (2) is discharged or charged with reverse polarity.

11. The method according to any one of Claims 1 to 10,
**characterized in that**
after the components (6) have been transferred to the surface (11), the photo-conductive layer (2) is discharged.

12. The method for transferring components, in which by means of repeated application of the method according to any one of Claims 1 to 11, different components (6) are placed on a surface (11).

13. Use of the method according to any one of Claims 1 to 12, for positioning and transferring spherical electrical contact elements (6) or electrical chips onto a surface, in particular a circuit board.

14. Use of the method according to any one of Claims 1 to 12, for positioning and transferring electrical contact elements (6), in particular contact balls, onto flip chips, BGA's (Ball Grid Arrays) and CSP's (Chip Size Packaging).

## Revendications

1. Procédé pour le transfert de composants électriques (6), en particulier de puces électriques, de DEL ou d'éléments de contact électrique en forme de billes, dans lequel des composants (6) réceptionnés par un support (1) sont positionnés sur une surface (11) et sont transférés sur la surface (11), **caractérisé par** les étapes suivantes :
- prévision d'un support (1) pouvant être chargé électrostatiquement, lequel présente une surface avec une couche photoconductrice (2),
- charge électrostatique de la couche photoconductrice (2) du support (1) et génération d'une structure de charge qui présente une géométrie avec laquelle les composants (1) individuels doivent être transférés sur la surface (11),
- amenée et application des composants (6) sur la surface de la couche photoconductrice (2) chargée électrostatiquement, seuls des composants (6) prévus conformément à la structure de charge de la couche photoconductrice (2) restant collés dessus,
- retrait des autres composants (6) du support (1),
- mise en contact des composants (6) adhérant sur la couche photoconductrice (2) avec la surface (11) et transfert des composants (6) sur la surface (11),
moyennant quoi grâce à un revêtement sélectif des composants (6) avec une couche diélectrique, il s'en suit une adhésion orientée des composants (6) sur le support (1).

2. Procédé selon la revendication 1, **caractérisé en ce que** l'on utilise des composants (6) identiques.

3. Procédé selon l'une des revendications 1 à 2, **caractérisé en ce que** la charge électrostatique de la couche photoconductrice (2) s'effectue à l'aide d'une charge à effet corona.

4. Procédé selon l'une des revendications 1 à 3, **caractérisé en ce que** la génération de la structure de charge s'effectue par exposition de la couche photoconductrice (2).

5. Procédé selon l'une des revendications 1 à 4, **caractérisé en ce que** la génération de la structure de charge s'effectue grâce à un procédé électrophotographique.

6. Procédé selon l'une des revendications 1 à 5, **caractérisé en ce qu'**avant l'application sur le support (1), les composants (6) sont chargés électriquement contrairement à la charge de surface de la couche photographique (2) chargée de manière structurée.

7. Procédé selon l'une des revendications 1 à 6, **caractérisé en ce que** le retrait des composants (6) s'effectue à l'aide de la force gravitationnelle s'exerçant sur les composants (6).

8. Procédé selon l'une des revendications 1 à 7, **caractérisé en ce que** le retrait des composants (6) s'effectue à l'aide d'un flux de fluide.

9. Procédé selon l'une des revendications 1 à 8, **caractérisé en ce qu'**avant la mise en contact, il y a un positionnement et une orientation du support (1) par rapport à la surface (11).

10. Procédé selon l'une des revendications 1 à 9, **caractérisé en ce que** lors du transfert des composants (6) sur la surface (11), la couche photoconductrice (2) est déchargée ou chargée avec une polarité opposée.

11. Procédé selon l'une des revendications 1 à 10, **caractérisé en ce qu'**après le transfert des composants (6) sur la surface (11), la couche photoconductrice (2) est déchargée.

12. Procédé pour le transfert de composants, dans lequel, grâce à l'utilisation répétée du procédé selon l'une des revendications 1 à 11, différents composants (6) sont appliqués sur une surface (11).

13. Utilisation du procédé selon l'une des revendications 1 à 12 pour le positionnement et le transfert d'éléments de contact électrique en forme de billes (6) ou de puces électriques sur une surface, en particulier une plaquette de circuit imprimé.

14. Utilisation du procédé selon l'une des revendications 1 à 13 pour le positionnement et le transfert d'éléments de contact électrique (6), en particulier de Contact-Balls, sur des Flip Chips, des BGA (Ball Grid Array's) et des CSP (Chip Size Packaging).
